# EUROPÄISCHE PATENTSCHRIFT

(11) **EP 0 584 683 B1**
(45) Veröffentlichungstag und Bekanntmachung des Hinweises auf die Patenterteilung: **27.03.1996**
(21) Anmeldenummer: 93113048.8
(22) Anmeldetag: 14.08.1993
(51) Int. Cl.: H05K 5/02

(54) **Anordnung zum Verschliessen einer Öffnung in einer Wand eines Gehäuses**
Arrangement for closing an opening in a wall of a casing
Dispositif de fermeture d'une ouverture dans une paroi d'une boîte

(30) Priorität: 22.08.1992 DE 9211305 U
(43) Veröffentlichungstag der Anmeldung: 02.03.1994
(73) Patentinhaber: VDO Adolf Schindling AG, D-60326 Frankfurt/Main (DE)
(72) Erfinder: Höni, Helmut, Dipl.-Ing. (FH), D-78733 Aichhalden (DE)

(56) Entgegenhaltungen:
- DE-A- 3 542 871
- DE-U- 8 137 939
- DE-U- 8 809 912

## Beschreibung

Die Erfindung betrifft eine Anordnung zum Verschließen einer Öffnung in einer Wand eines Gehäuses, wobei die Öffnung dem Durchführen eines an einer Leitung angebrachten Steckers dient, welcher mit einer innerhalb des Gehäuses befindlichen Steckersockel kuppelbar ist.

Elektrische oder auch optische Verbindungsleitungen zwischen Sensoren und diesen zugeordneten Meß- bzw. Datenerfassungsgeräten, Verbindungsleitungen zwischen derartigen Geräten und solchen, die von diesen gesteuert oder geregelt werden sollen, Verbindungsleitungen zu Handeingabegeräten, zu Anzeige- oder Druckaggregaten und die Verbindungsleitungen für deren Stromversorgung sind vorkonfektioniert aus montagetechnischen Gründen im allgemeinen anschlußfertig d. h. mit geeigneten Steckverbindungsmitteln versehen. Demgemäß sind auch die geräteseitigen Kupplungselemente vorzugsweise an einer geeigneten Gehäusewand angebracht. Die Folge davon ist, daß ein relativ hoher Montageaufwand für das Anbringen des Steckersockels und dessen Kontaktierung mit einer Leiterplatte innerhalb des Gerätes in Kauf zu nehmen ist und ein solches Gerät, wenn es - von der Standfläche abgesehen - von allen Seiten beobachtet werden kann, eine ästhetisch weniger vorteilhafte Gehäusewand aufweist. Zusätzlicher Aufwand ist erforderlich bei Geräten, bei denen die erfaßten Daten von dokumentarischem Wert sind oder Geräten, die beispielsweise einer Preisberechnung dienen, kurzum bei Geräten, die der Eichpflicht unterliegen und somit von außen zugängliche Steckverbindungen plombiert sein müssen. Ein solches Gerätekonzept ist auch insofern unvorteilhaft, als bei Geräten, die eingebaut werden, in der Regel eine geringe Einbautiefe angestrebt wird, von außen anbringbare Steckverbindungen aber den Raumbedarf der Geräte In Einbaurichtung erheblich vergrößern.

Einen Ansatz zur Verbesserung dieses Gerätekonzeptes zeigt DE-U-88 09 912, d. h.in diesem Gebrauchsmuster ist eine Anordnung beschrieben, bei der die Steckersockel unmittelbar auf einer Leiterplatte befestigt sind, in einer Wand des Gerätegehäuses ein solcher Ausschnitt ausgebildet ist, daß ein mit einem Kabel verbundener Stecker durch die Gehäusewand hindurchgeführt werden kann und ein Bauteil vorgesehen ist mittels dessen, der dem Durchführen des oder der Stecker dienende Wandausschnitt abgedeckt werden kann.

Diese Lösung ist insofern inkonsequent, als von den vorgesehenen Quetschverbindungen in dem abdickenden Bauteil abgesehen, die Verbindungsleitungen wenigstens einseitig noch offen sein müssen, d. h. nicht mit einem Stecker abgeschlossen sein dürfen, und das Bauteil von außen befestigt und somit auch plombiert werden muß.

DE-U- 8137939 beschreibt ein Gehäuse in Form eines nach oben offenen Bechers mit einer eine Kammer bildenden Ausformung, in die ein Anschlußkabel eingeführt ist und in der es durch eine Zugentlastung gehalten wird. Diese umfaßt einen von oben in die Kammer einschiebbaren, das Anschlußkabel auf den Boden der Kammer drückenden Quersteg, der zwischen an den Kammerseitenwänden vorgesehenen Führungsrippen geführt und mit diesen verrastet ist.

Unter der Voraussetzung, daß der Vorteil genutzt wird, Verbindungsleitungen von Geräten in einer fertig konfektionierten Form, d. h. mit Steckern versehen, innerhalb der Geräte zu kontaktieren, war die Aufgabe gestellt, eine für die Serienfertigung geeignete Anordnung zum Verschließen der Durchführungsöffnung in der betreffenden Gehäusewand eines Gerätes zu schaffen.

Die erfindungsgemäße Lösung sieht vor, daß als Verschlußelement eine Platte vorgesehen ist, daß an der Geräteinnenseite der Gehäusewand Führungsmittel für ein wandparalleles Verschieben der Platte ausgebildet sind, daß an der Platte Riegel federnd angeformt und an der Gehäusewand den Riegeln zugeordnete Hinterschnitte vorgesehen sind und daß an der Platte und/oder der Gehäusewand ein dem Querschnitt der durchzuführenden Leitung entsprechender Ausschnitt vorgesehen ist.

Der besondere Vorteil der Erfindung ist darin zu sehen, daß das Verschlußelement sowie dessen an der Gehäusewand ausgebildete Führungs- und Befestigungsmittel in einfacher Weise spritzgußtechnisch herstellbar sind und die Montage des Verschlußelementes, das mittelbar durch Zusammenfügen und Plombieren der Gehäuseteile plombiert wird, lediglich durch wandparalleles Verschieben und Verrasten mit der Gehäusewand erfolgen kann. Auf ebenso einfache Weise und, ohne daß ein Werkzeug erforderlich ist, ist das Verschlußelement auch entfernbar. Ferner lassen sich mehrere nicht nicht notwendigerweise in unmittelbarer Nähe beieinanderliegende Öffnungen verschließen. Außerdem ist das Verschlußelement derart ausbildbar, daß beispielsweise für Kabel, deren Leitungen unmittelbar, also steckerlos, mit Leiterbahnen im Gerät kontaktiert werden, die Funktion der Zugentlastung integriert ist, so daß hierfür zusätzliche Mittel und Montagearbeitgänge nicht mehr erforderlich sind. Zwar sind bei der gefundenen Lösung die Verbindungsleitungen dem betreffenden Gerät fest zugeordnet, der ästhetische Eindruck der Gehäusewand, an der die Leitungen herausgeführt sind, ist aber wesentlich verbessert und der Raumbedarf gegenüber an einer solchen Wand angebrachten Steckerkupplungen erheblich reduziert. Ferner entfällt das Plombieren eines oder mehrer Steckverbindungen, mit anderen Worten, die gefundene Lösung ist umso vorteilhafter je mehr Leitungsdurchführungen durch die Gehäusewand erforderlich sind.

Im folgenden sei ein Ausführungsbeispiel der Erfindung anhand der beigefügten Zeichnungen näher erläutert. Es zeigen:
Fig. 1 eine perspektifische Übersichtsdarstellung eines Gerätes, in welchem die neuerungsgemäße Anordnung vorgesehen ist.
Fig. 2 einen Aufbruch gemäß der Schnittlinie A in Fig. 1.
Fig. 3 eine Perspektivdarstellung des für die in Fig. 1 dargestellten Leitungskonfiguration geeigneten Verschlußelementes gemäß der Ansicht Pfeil B in Fig. 2.
Fig. 4 einen Teilschnitt des Gerätes gemäß der Schnittlinie C in Fig. 2 mit einer Ansicht der Gehäusewand, an welcher das Verschlußelement gemäß Fig. 3 angeordnet ist.

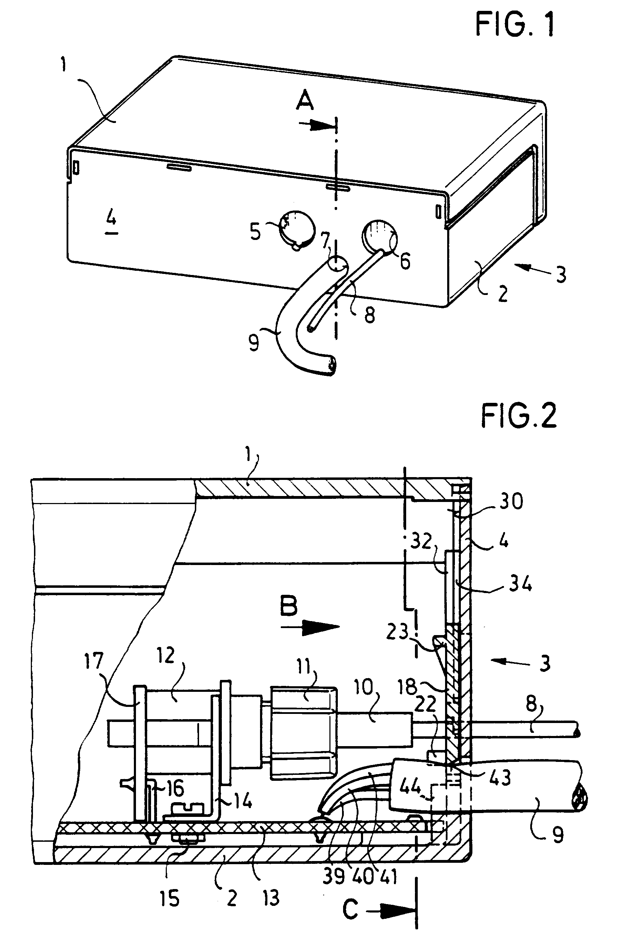

Die Fig. 1 zeigt ein aus zwei Gehäusebauteilen 1 und 2 in geeigneter Weise zusammengefügtes Gehäuse 3 eines vorzugsweise elektronischen Gerätes, an dessen einer Wand 4 im dargestellten Ausführungsbeispiel der Rückwand des Gehäuses 3 Öffnungen 5,6 und 7 vorgesehen sind. Die Öffnungen 5 und 6 dienen dem Durchführen von Steckern und diesen zugeordneten Geber bzw. Datenleitungen- eine ist dargestellt und mit 8 bezeichnet - durch die Öffnung 7 ist ein der Stromversorgung dienendes Kabel 9 geführt. Der Vollständigkeit halber sei erwähnt, daß in dem dargestellten Ausführungsbeispiel als Geber bzw. Datenleitungen Lichtwellenleiter vorgesehen sind und somit die Öffnungen 5 und 6 vorzugsweise entsprechend den Konturen der für den Lichtwellenleiteranschluß üblicherweise verwendeten Steckern ausgebildet sind.

Die Fig. 2 zeigt einen Stecker 10, welcher mittels einer Überwurfmutter 11 an einem lichtelektischen Wandler 12 befestigt ist. Der Wandler 12 ist seinerseits auf einer Leiterplatte 13 des Gerätes mittels eines Halters 14 befestigt (Schraubverbindung 15). Kontaktstifte 16 bilden die elektrische Verbindung zwischen der Leiterplatte 13 und einem dem Wandler 12 zugeordneten Leiterbahnträger 17.

Die Fig. 2 zeigt ferner eine mit 18 bezeichnete Platte, die an der Innenseite der Gehäusewand 4 angeordnet ist und dem Verschließen der Öffnungen 5 und 6 dient. D. h. die Öffnungen 5 und 6 werden nach der Montage der Stecker - im dargestellten Ausführungsbeispiel ist nur einer, 10, vorgesehen - bis auf eine Restöffnung der Leitung lediglich durch wandparallelles Verschieben der Platte 18 abgedeckt.

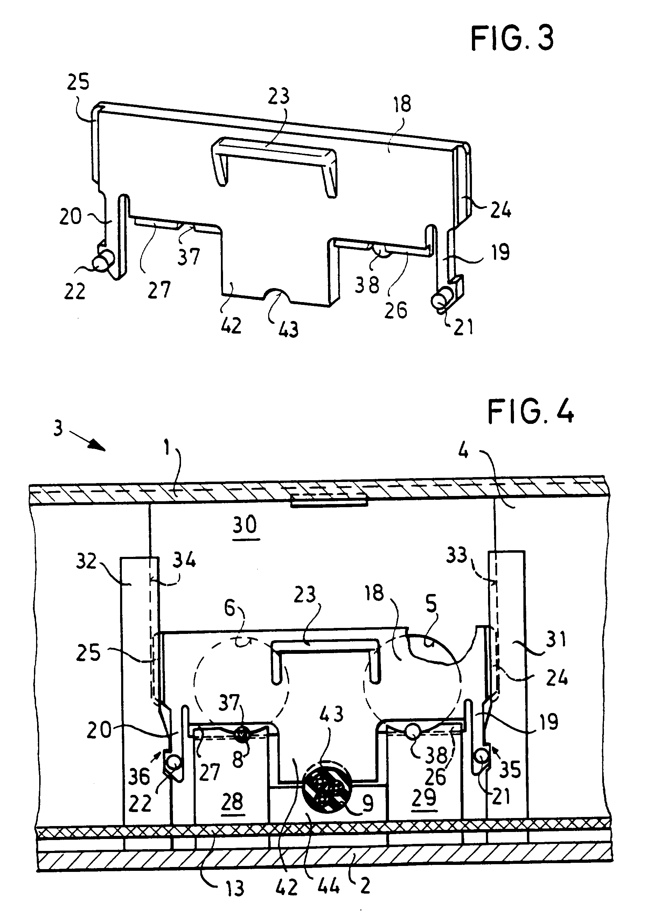

Wie aus der Figur 3 ersichtlich ist, sind an der Platte 18 beidseitig Riegel 19 und 20 federnd angeformt. Auf den Riegeln 19 und 20 angeformte Zapfen 21 und 22 dienen dem werkzeuglosen Lösen der Riegelverbindung der Platte 18 mit der Gehäusewand 4. Ein Griffelement an 23 dient der leichteren Handhabung der Platte 18 beim wandparallellen Verschieben, da im Hinblick auf eine ausreichende Dichtung zwischen der Gehäusewand 4 und der Platte 18 eine spielfreie Führung anzustreben ist und sich somit eine gewisse Schwergängigkeit ergibt. Seitlich an der Platte 18 ausgebildete Falze 24 und 25 ermöglichen eine möglichst raumsparende Anordnung. In Einführrichtung der Platte 18 angeordnete Falze 26 und 27 sichern durch gegenseitiges Überlappen mit an der Gehäusewand 4 angeformten Wandvorsprüngen 28 und 29 die Platte 18 gegen ein Eindrücken in das Gehäuse 3 von außen. Um Materialanhäufung zu vermeiden, ist die Gehäusewand 4, wie aus Fig. 4 ersichtlich ist, mit einer Freisparung 30 versehen. Ebenfalls an der Gehäusewand 4 angeformte Wangen 31 und 32 bilden, in dem sie die Freisparung übergreifen, Schlitze 33 und 34 zur Führung der Platte 18, die aufgrund der Falzverbindung mit den Wangen 31 und 32 im wesentlichen ebenflächig mit diesen angeordnet ist. Außerdem sind in Verbindung mit der Freisparung 30 den Riegeln 19 und 20 zugeordnete Hinterschnitte 35 und 36 ausgebildet.

Wie ferner noch aus Fig. 3 ersichtlich ist, ist an der Platte 18 ein halbkreisförmiger Auschnitt 37 vorgesehen, der zusammen mit einem nicht bezeichneten halbkreisförmigen Ausschnitt in der Gehäusewand 4 eine dem Querschnitt des Lichtwellenleiters 8 entsprechende Teilöffnung der Öffnung 6 für den Durchtritt des Lichtwellenleiters 8 ergibt. Wird diese Teilöffnung nicht benutzt, so kann sie durch eine an der Platte 18 oder an der Gehäusewand 4 ausbrechbar ausgeformte Blende 38 abgedeckt werden.

Bei dem dargestellten Ausführungsbeispiel hat die Platte 18 die zusätzliche Funktion der Zugentlastung für das Kabel 9, dessen Leiter 39, 40 und 41 unmittelbar mit Leiterbahnen der Leiterplatte 13 kontaktiert sind.
Eine an der Platte 18 angeformte Zunge 42 wirkt zusammen mit den Riegeln 19 und 20 als Niederhalter. Dabei kann einerseits die Ausparung 43, in Form einer Schneide ausgebildet, andererseits dem Kabel 9 eine verbreiterte Auflage 44 zugeordnet sein. Die maßliche Abstimmung für die zwischen der Auflage 44 und der Zunge 42 ausgebildete Öffnung muß die Funktion der Zugentlastung für das Kabel 9 gewährleisten, d. h. es muß eine Quetschverbindung in Bezug auf das Kabel 9 gegeben sein.

An Stelle der Öffnungen 5 und 6 ist selbstverständlich auch eine Öffnung ausbildbar, die nicht zwingend einen kreisförmigen Querschnitt aufweist. Durch eine solche Öffnung sind mehrere unterschiedlich gestaltete Stecker mit Kabeln bzw. Leitungen von unterschiedlichem Querschnitt in das Gerät bei dessen Montage, d. h. solange das Gerät noch offen ist, einführbar und mit entsprechenden Sockeln kuppelbar bzw. unmittelbar mit einer Leiterplatte kontaktierbar. Die zur Durchführung der Leitungen erforderlichen Ausschnitte bzw. Aussparungen lassen sich beispielsweise bei Flachbandkabeln sowohl in der Gehäusewand 4 als auch in der Platte 18 oder auf beide Bauteile verteilt ausbilden. Vorzugsweise sind die Riegelverbindungen 19/35 und 20/36 und die vorgesehenen Ausschnitte maßlich derart aufeinander abgestimmt, daß auch bei den Geber- und Datenleitungen eine geringe elastische Verformung der Leitungsisolation und somit eine Abdichtung und eine gewisse Zugentlastung erfolgt.

## Patentansprüche

1. Anordnung zum Verschließen einer Öffnung (5,6) in einer Wand (4) eines Gehäuses (1), wobei die Öffnung (6) dem Durchführen eines an einer Leitung (8) angebrachten Steckers (10) dient, welcher mit einem innerhalb des Gehäuses (1) befindlichen Steckersockel kuppelbar ist,
dadurch gekennzeichnet,
daß als Verschlußelement eine Platte (18) vorgesehen ist,
daß an der Geräteinnenseite der Gehäusewand (4) Führungsmittel 30, 31, 32, 33, 34) für ein wandparallelles Verschieben der Platte (18) ausgebildet sind,
daß an der Platte (18) Riegel (19, 20) federnd angeformt und an der Gehäusewand (4) den Riegeln (19, 20) zugeordnete Hinterschnitte (35, 36)
vorgesehen sind und
daß an der Platte (18) und/oder der Gehäusewand (4) ein dem Querschnitt der durchzuführenden Leitung (8) entsprechender Ausschnitt vorgesehen ist.

2. Anordnung nach Anspruch 1,
dadurch gekennzeichnet,
daß an der Platte (18) Griffelemente (21, 22, 23) für das Lösen der Riegelverbindungen (19, 35/20, 36) und das Verschieben der Platte (18) ausgebildet sind.

3. Anordnung nach Anspruch 1,
dadurch gekennzeichnet,
daß zur Sicherung eines durch die Gehäusewand (4) geführten steckerfreien Kabels (9) die Platte (18) und die Riegelverbindungen (19, 35/20, 36)
derart ausgebildet sind, daß in bezug auf das Kabel (9) eine Quetschverbindung besteht.

## Claims

1. An arrangement for the closure of an opening (5, 6) in a wall (4) of a casing (1), the opening (6) serving for the passage of a connector (10) fitted to a lead (8), which connector can be coupled to a connector socket situated inside the casing (1),
characterised in
that a plate (18) is provided as closing element, that guide means (30, 31, 32, 33, 34) for displacement of the plate (18) parallel to the wall are formed on the inside of the casing wall (4),
that bolts (19, 20) are elastically formed on the plate (18) and undercuts (35, 36) assigned to the bolts (19, 20) are provided on the casing wall (4) and that a cut-out corresponding to the cross-section of the lead (8) to be passed through is provided on the plate (18) and/or the casing wall (4).

2. An arrangement as claimed in claim 1,
characterised in
that grip elements (21, 22, 23) are formed on the plate (18) for release of the bolt connections (19, 35/20, 36) and displacement of the plate (18).

3. An arrangement as claimed in claim 1,
characterised in
that, to secure a cable (9) without connector passed through the casing wall (4), the plate (18) and the bolt connections (19, 35/20, 36) are formed in such a way that a crimp connection exists in relation to the cable (9).

## Revendications

1. Arrangement pour l'obturation d'un orifice (5, 6) dans une paroi (4) d'un boîtier (1), ledit orifice (6) servant au passage d'un connecteur (10) qui est monté sur une ligne (8) et peut être raccordé à un socle de connexion situé à l'intérieur dudit boîtier (1),
caractérisé par le fait
que comme élément d'obturation est prévue une plaque (18) et
que sur la surface intérieure de la paroi de boîtier (4) sont prévus des moyens de guidage (30, 31, 32, 33, 34) pour une translation parallèle à la paroi de ladite plaque (18),
que des verrous (19, 20) sont élastiquement moulés sur la plaque (18) et des contre-dépouilles (35, 36) associées auxdits verrous (19, 20) sont prévues sur la paroi de boîtier (4) et
que sur ladite plaque (18) et/ou la paroi de boîtier (4) est prévue une découpe correspondant à la section de la ligne (8) à faire passer.

2. Arrangement selon la revendication 1,
caractérisé par le fait
que sur la plaque (18) sont formés des éléments de préhension (21, 22, 23) pour le désassemblage des verrouillages (19, 35/20, 36) et la translation de ladite plaque (18).

3. Arrangement selon la revendication 1,
caractérisé par le fait
que, pour l'immobilisation d'un câble sans connecteur (9) acheminé à travers la paroi de boîtier (4), la plaque (18) et les verrouillages (19, 35/20, 36) sont réalisés de telle sorte qu'il existe, par rapport audit câble (9), une connexion sertie.
